# EUROPEAN PATENT SPECIFICATION

(11) **EP 1 712 298 B1**
(45) Date of publication and mention of the grant of the patent: **10.06.2009**
(21) Application number: 05008047.2
(22) Date of filing: 13.04.2005
(51) Int. Cl.: B05D 1/18, B05D 1/20, B05D 7/00

(54) **Organic thin film insulator**
Organischer dünnschichtiger Isolator
Film mince organique isolant

(43) Date of publication of application: 18.10.2006
(73) Proprietor: Universität Heidelberg, 69117 Heidelberg (DE)
(72) Inventor: Grunze, Michael, D-69151 Neckargmünd (DE); Zharnikov, Michael, D-69221 Dossenheim (DE); Tai, Yian, 106, Taipei (TW)
(74) Representative: HOFFMANN EITLE

(56) References cited:
- WO-A-03/008646
- US-A- 5 728 431
- US-A1- 2004 202 875
- US-B1- 6 562 398

## Description

### Field of the invention

The present invention relates to a layer system with a monolayer thick organic thin film having electrical insulation properties, and a microelectronic or spintronic device comprising the same, such as e.g. a field effect transistor or a magnetic tunnel junction.

### Discussion of the background art

Self-assembled monolayers (SAMs) are well-ordered and densely packed organic films, composed of chemisorbed rod-like molecules (see A. Ulman, An Introduction to Ultrathin Organic Films: Langmuir-Blodgett to Self-Assembly; Academic Press: New York, 1991; Chem. Rev. 96, 1533 (1996)). Their use has been proposed for new materials in electronics and spintronics. For example, SAMs have the potential to be used as ultrathin insulator layers in standard and newly designed electronic elements, providing an alternative to commonly used oxide dielectrics such as e.g. SiO₂ or Al₂O₃. A barrier for the above-mentioned applications of SAMs is the difficulty to fabricate a stable metal layer on their surface, i.e. at the SAM-ambient interface. Such a layer could serve as the top electrode in a molecular device, as source and drains electrodes in thin film transistors, or as the top ferromagnetic layer in a magnetic tunnel junction.

Despite the cartoons representing well-defined metal-SAM-substrate structures found in the literature (see e.g. Schön et al., Nature 413, 713 (2001)), a stable metal layer on top of a SAM has not been demonstrated yet. Studies of metal adsorption onto the SAM surface show that metal atoms usually penetrate into the SAM layer and diffuse to the SAM-substrate interface (see Czanderna and D. R. Jung, Crit. Rev. Sol. State. Mat. Sci. 19, 1 (1994); Epple et al., Langmuir 18, 773 (2002); Walker et al., Appl. Phys. Lett. 84, 4008 (2004)). Diffusion occurs over static and dynamic transient channels, which are structural defects in the SAM (e.g. domain boundaries, etc.) and irregularities related to the moving of the SAM constituents (see Hooper et al., J. Am. Chem. Soc. 121, 8052 (1999); Fisher et al., J. Am. Chem. Soc. 124, 5528 (2002)). In this regard, the SAM homogeneity is important, since it affects the density of the transient channels. While it has been reported that diffusion into the organic film can be reduced for selective systems e.g. by cooling or introduction of reactive functional groups (Czanderna et al., Crit. Rev. Sol. State. Mat. Sci. 19, 1 (1994); Hooper et al., J. Am. Chem. Soc. 121, 8052 (1999); Fisher et al., J. Am. Chem. Soc. 124, 5528 (2002);Weckenmann, et al., Chem. Mater. 16, 621 (2004); de Boer et al., Langmuir 20, 1539 (2004)), none of the described systems is fully satisfactory in terms of stability and insulation properties. Moreover, none of the described systems provides an electrically conductive layer of a metal of relatively low reactivity, such as nickel, cobalt, or iron, on top of a self-assembled monolayer.

US 6,526,398 provides a method of ionically and/or electrically insulating a surface of a material. The method comprises attaching to the surface a self-assembling monolayer membrane.

US 2004/0202875 relates to organic superlattices formed by molecular layer epitaxy (MLE) for use in a variety of electronic applications.

WO 03/008646 discloses self-assembling monolayers.

US 5,728,431 provides a process for the formation of self-assembled polymer layers on a pretreated metallic substrate.

### Summary of the Invention

It is the object underlying the present invention to provide such systems and microelectronic devices containing the same.

To solve this objective, the present invention provides a layer system, comprising a substrate, being either a bulk substrate or a thin film deposited on it, a monolayer of organic molecules, which is chemisorbed on the substrate and cross-linked in the lateral direction, and a deposited electrically conductive, ferromagnetic or semiconductor layer on top of the monolayer, wherein the layer system has a resistance in the range of 10 MΩcm² or more. The present invention also provides a microelectronic device comprising the layer system of the present invention, such as e.g. a field effect transistor or a tunnel junction magnetic memory cell.

### Figures

Figure 1 represent graphical illustrations of the layer system of the present invention: two different layer arrangements are shown in Figures 1b and 1c. Figure 1a is a graphical illustration of cross-linked TPDMT on a substrate and, deposited thereon, a layer of metallic atoms.

Figure 2 shows the ISS depth profiles for Ni and Au (open circles) after Ni deposition on TPMA/Au (Figure 2a), TPDMT/Au (Figure 2b) and cross-linked TPDMT/Au (Figure 2c), respectively (θ_{Ni}=10.0). The profiles were measured by subsequent acquisition of the ISS spectra of Ni and Au during the erosion of the samples by the He⁺ beam. The depth profiles of Ni were acquired 5 min (up triangles) and 24 hours (upside down triangles) after Ni deposition. The SAM region is marked gray.

Figure 3 shows relative intensities of the C 1s (upward triangles, solid line) and Ni 2p (upside down triangles, dashed line) XPS signals as a function of the photoelectron takeoff angle for Ni deposited on pristine (a) and cross-linked (b) TPDMT/Au (θ_{Ni}=10.0). The irradiation dose was 45 mC/cm².

Figure 4 illustrates the difference of the NEXAFS spectra acquired at X-ray incidence angles of 90° and 20° as a function of Θ_{Ni} for pristine (a) and cross-linked (b) TPDMT/Au. The irradiation dose was 45 mC/cm².

### Detailed Description of the Invention

Layer systems comprising a substrate, a monolayer of molecules which is chemisorbed on the substrate and cross-linked in the lateral direction are known in the art. For example, WO 01/23962 A2 describes such a system.

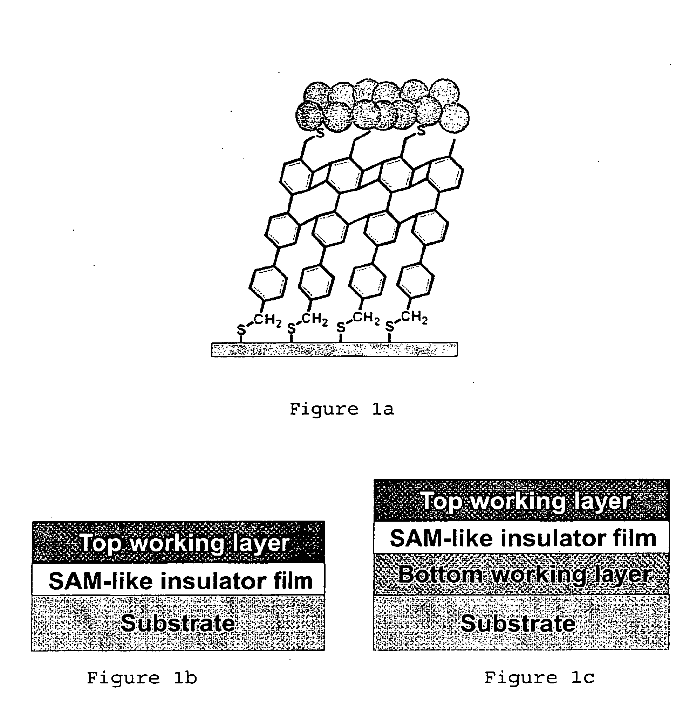

The monolayer of molecules can be prepared both on a bulk support and on a thin film (bottom working layer) deposited on a bulk support, forming a sandwich structure as far as the monomolecular film is covered by a top working layer (see Figure 1). The thickness of the bottom working layer can range from several monolayers to several tens or even hundreds nm. As to the substrate material, metallic, semiconductor or oxide substrates can be used. Preferred examples thereof comprise gold, silver, copper, aluminum, iron, cobalt, nickel, platinum, and alloys or mixtures thereof, as well as silicon, germanium, gallium arsenide, indium-tin oxide, all of which may possibly be doped to modify the semiconductor properties, as well as alloys thereof. Particularly for use as a gate dielectric, doped silicon is preferred as the substrate. For magnetic tunnel junctions, the substrate is preferably ferromagnetic, substrates made of iron, cobalt, and/or nickel being particularly preferred.

The laterally cross-linked monolayer of the layer system according to the invention is composed of chemisorbed molecules. The chemisorbed molecules have preferably a molecular weight of less than 1000, more preferably less than 500. They are preferably capable of forming self-assembled monolayers. The chemisorbed molecules preferably comprise an aromatic or heteroaromatic moiety, particularly preferred aromatic moieties being selected from the group consisting of phenyl, biphenyl, terphenyl, naphthalene, and anthracene, and particularly preferred heteroaromatic moieties are selected from the group consisting of bipyridine, terpyridine, thiophene, bithienyl, terthienyl, and pyrrole. Terphenyl is particularly preferred.

The compounds forming the cross-linked monolayer comprise a group for chemisorption on the substrate (in the following referred to as the "anchor group"). Moreover, the compounds have preferably a functional group at the opposite end of the molecule, in a preferred embodiment at the opposite end of the aromatic/heteroaromatic backbone. The choice of the functional group depends on the material of the top layer to get a chemical linkage by building individual bonds between the functional groups and atoms or molecules of the top layer. Preferred functional groups are -SH, -OH, -COOH, - COOH₃, -CH₂OH, -NH₂, and -NO₂. The thiol group (-SH) is particularly preferred, especially if the top layer is composed of a metal.

The anchor group that chemically anchors the monolayer constituents to the substrate is selected according to the substrate material (see below). In particular, carboxy, thiol, selenol, trichlorosilyl, trialkoxysilyl, phosphonate, hydroxamic acid, and phosphate groups can be used. In a preferred embodiment, the anchor groups is either directly bound to the aromatic and/or heteroaromatic spacer or there can be a linker, e.g. a chain of 1 to 6 methylene groups between the headgroup and spacer, e.g. to achieve a better molecular packing.

The nature of the anchor group is tailored to the particular substrate material, in a way known to one skilled in the art. For example, trichlorosilanes or trialkoxysilanes such as trimethyloxysilane, triethoxysilane, etc. are particularly suitable as anchor groups for oxidized silicon surfaces. Alcohol groups can be used for anchoring for hydrogenated silicon surfaces. For noble and 3d metal substrates, thiol or selenol groups can be used as anchor groups; for oxidized metal surfaces such as iron or chromium, suitable anchor groups are phosphonic acids, carboxylic acids, or hydroxamic acids.

In a particularly preferred embodiment of the present invention, the layer system includes a monolayer composed of molecules satisfying the general formula An-Ar-Fn, wherein An is the anchor group as defined above, optionally comprising a spacer, Ar is the aromatic/heteroaromatic moiety as defined above, and Fn is the functional group as defined above, optionally comprising a spacer. Particularly preferred compounds of the above formula comprise [1,1'-biphenyl]-4,4'-dimethanethiol (BPDMT) and [1,1';4',1"-terphenyl]-4,4'-dimethanethiol (TPDMT).

The present invention thus allows the fabrication of a monomolecular thick insulation film (on any substrate, including thin film) in a SAM fashion, with the subsequent fabrication of a top working (e.g. electrically conductive, ferromagnetic, or organic) layer. The fabrication procedure may combine specific functionalization of the film's constituents with their extensive cross-linking in the lateral direction. While the functionalization ensures 2D growth and chemical adherence of the working layer, the cross-linking closes the diffusion channels, ensuring the persistence of the working layer constituents on the insulator film surface and thus the insulation properties of the monomolecular film.

The layer systems of the present invention can be prepared in the following series of process steps:
(a) selection and preparation of a bulk substrate,
(b) modification of the bulk substrate surface, if necessary,
(c) fabrication of the pristine monolayer
(d) treatment of the substrate obtained in step (c) with high-energy beam radiation so that the monolayer is covalently cross-linked in the lateral direction,
(e) adsorbing the metal atoms or organic molecules to provide the (e.g. electrically conductive) layer on top of the monolayer.

In step (a), a bulk substrate suitable for a particular application should be selected and cleaned. In some cases, the bulk substrate should be freshly prepared, e.g. as a thick film.

In step (b),the surface of the bulk substrate can be, if necessary, chemically modified to provide a chemical link to the anchor groups of the SAM constituents. Another possibility is the deposition of a thin film, serving as the bottom working layer (see Figure 1).

In step (c), the pristine SAM is formed by e.g. immersion procedure or evaporation from the gas phase. The choice of the SAM constituents and, in particular, the anchor and functional groups depends on the substrate (or bottom working layer) and top working layer.

In step (d), the monolayer is cross-linked by its extensive irradiating. For this purpose, electron, X-ray, or UV irradiation may be employed.

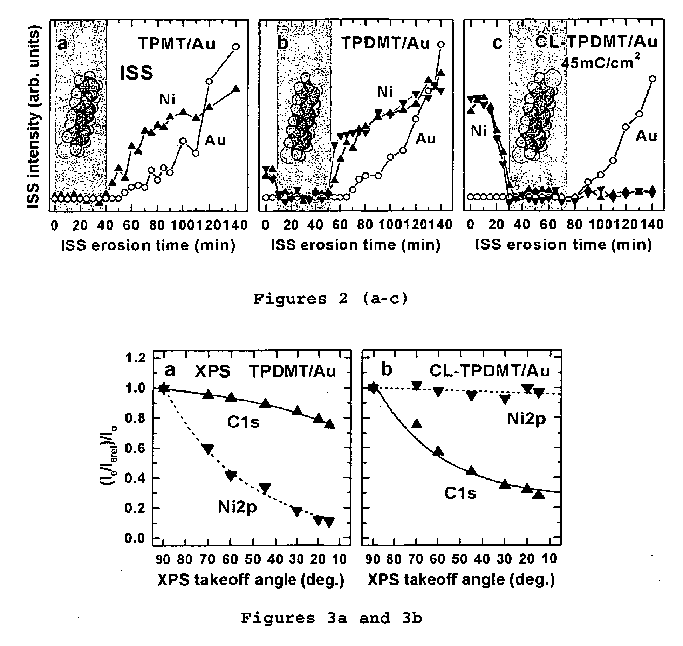

For electron irradiation, a large-area illuminating electron source can be used, such as e.g. a "flood gun" or a set-up as described in Fig. 2 of Hild et al., Langmuir, 14, 342-346 (1998). The electron energies from 10 to several hundreds eV can be used.

For large-area cross-linking by means of X-ray or UV irradiation, light sources available in the prior art can be used.

If in step (c), instead of applying a monolayer of aromatic and/or heteroaromatic compounds, compounds with partially or completely hydrogenated aromatic or heteroaromatic moieties, such as cyclohexyl, bicyclohexyl, tercyclohexyl, partially or completely hydrogenated naphthalene or anthracene, are applied, dehydrogenation to the corresponding aromatic or heteroaromatic compounds can occur in step (d), in addition to cross-linking in the lateral direction.

In one embodiment of the invention, the cross-linking can be carried out with lateral structuring, e.g. by means of a finely focused ionising electron, ion, or photon beam radiation.

A large-area illuminating electron source combined with a shadow mask can be used for lateral structuring, so that only the open areas are exposed to the electrons. Also suitable for lateral structuring are focused electron or X-ray beams, provided by suitable experimental setups and scanned over the sample surface.

For lateral structuring by means of electromagnetic radiation, masks appropriate for the respective wavelength range or scanning by means of a suitable light guide (optical fiber) are available.

If lateral structuring is carried out, it is possible to provide a structured surface with areas having a high affinity to the metal atoms or organic molecules forming the (e.g. electrically conductive) top layer and areas having a low affinity to the metal atoms or organic molecules forming the (e.g. electrically conductive) top layer. Hence, the top layer (e.g. electrically conductive layer) can be provided in a pattern on the monolayer. For example, if the compounds contain a nitro group as a functional group (Fn), then these nitro groups can also be converted to amino groups in the impact zone of the cross-linking beam radiation in step (d).

The top working layer is an electrically conductive layer (e.g. gold, silver, copper, or aluminium), ferromagnetic layer (e.g. iron, cobalt, or nickel) or a semiconductor layer. Besides metals, organic semiconductors such as e.g. pentacene may also be used. Ferromagnetic layers are particularly preferred, for example layers made of nickel, iron, or cobalt, particularly if the substrate is also ferromagnetic.

The fabrication of the top working layer can be performed by different means, e.g. by its deposition from the gas phase, from a metal or organic evaporated, or by electrochemical means.

Even after adsorption, the monolayer is preferably a self-assembled monolayer, i.e. is a well-ordered and densely packed organic film, as, e.g., confirmed by NEXAFS spectroscopy.

Its thickness is preferably in the range of 0.3 to 5 nm, more preferably in the range of 1.2 to 3 nm. The thickness is mainly determined by the length of the film constituents, corrected for their tilt in the film (the average tilt angle can be derived by IR or NEXAFS spectroscopy). The thickness can be directly estimated by ellipsometry or X-ray photoemission, using either the substrate or adsorbate signals or both of them. According to the present invention, X-ray photoemission is the preferred method for measuring the thickness.

The layer system of the present invention has a resistance of 10 MΩ cm² or more, preferably in the range of 12 to 20 MΩ cm². The resistance can be, e.g., determined by electrochemical measurements, i.e. impedance spectroscopy or using conducting probe atomic force microscopy (see e.g. Wold et al, J. Phys. Chem. B 106, 2813 (2002)) or mercury drop method (see e.g. Holmlin et al., J. Am. Chem. Soc. 123, 5075 (2001)). According to the present invention, impedance spectroscopy is the preferred method for measuring the resistance.

The layer system of the present invention has preferably a capacitance of 0.8 µF cm² or more, more preferably in the range of 1 to 1.5 µF cm². The capacitance can be, e.g., determined using electrochemical measurements, i.e. impedance spectroscopy.

The use of the monomolecular insulator film of the present invention in microelectronic devices can provide significant advantages. For example, the application of such a film as a gate dielectric in organic thin film transistors can result in lowering of the operation voltage and a better performance of such a device (cf. Halik et al., Nature, 431, 963 (2004)). Also, the use of the monomolecular insulator film of the present invention as the insulator in a tunnel junction magnetic memory cell (Kortright et al., J. Magn. Magn, Mat. 207, 7 (1999); Tsymball et al., J. Phys. Condens. Matter. 15, R109 (2003)) can result in a better coupling of the ferromagnetic layers and help to avoid the problem of the ferromagnet-insulator interface degradation, which occurs due to the migration of oxygen from a conventional oxide insulator. In such a memory cell, the invention thus provides a trilayer system, comprising a ferromagnetic bottom film, a monolayer of molecules chemisorbed on it, and an ferromagnetic layer on the top of the monolayer, the monolayer of chemisorbed molecules being defined as detailed above.

### Example: Ni adsorption on cross-linked and pristine TPDMT/Au

### Preparation of the layer system

Gold substrates were prepared by thermal evaporation of 100 nm of gold onto Si(100) wafers (Silicon Sense) primed with a 5 nm titanium adhesion layer. The resulting metal films were polycrystalline, with a grain size of 20-50 nm. The grains predominantly exhibit an (111) orientation. Subsequently, SAMs were prepared by immersion of the Au substrates in the solution of [1,1' ;4' ,1" -terphenyl]-4,4"-dimethanethiol (TPDMT) (for details, see Shaporenko et al., J. Phys. Chem. B 108, 14462 (2004); Tai et al., J. Phys. Chem. B 108, 16806 (2004); Tai et al., Appl. Phys. Lett. 85, 6257 (2004)). After immersion, the samples were carefully rinsed with pure solvent and blown dry with argon. No evidence for impurities or oxidative degradation products was found. The fabricated TPMT and TPDMT films were then irradiated by electrons with a kinetic energy of 10 eV. The dose was calculated by multiplication of the exposure time by the current density (approx. 2.5 µA/cm²), which was calibrated by a Faraday cup. Ni (Goodfellow, 99.999% purity) was evaporated from a commercial e-beam evaporator (Omicron) with a deposition rate of 0.2 nm per minute; the rate was calibrated by a commercial quartz crystal microbalance sensor (Inficon). The evaporation was performed at a base pressure better than 1.5x10⁻⁹ Torr; the substrates were kept at room temperature.

### Analytical methods

The pristine SAMs were characterized by XPS, NEXAFS spectroscopy, Infrared-Reflection Absorption Spectroscopy, ellipsometry, and contact angle measurements. The evaporation of Ni was monitored by XPS, NEXAFS spectroscopy, ISS, AFM, and electrochemical measurements. All experiments were performed at room temperature. The XPS, HRXPS, ISS, and NEXAFS spectroscopy measurements were carried out in-situ, under UHV conditions. AFM and electrochemical measurements were performed ex-situ.

The XPS experiments were carried out using two different spectrometers. One of them was equipped with a Mg Kα X-ray source and a LHS11 analyzer. The other used a synchrotron light (HE-SGM, BESSY II) as the primary source and was equipped with a VG CLAM 2 analyzer. The spectra acquisition was carried out at variable emission geometry with an energy resolution of approx. 0.9 eV and approx. 0.4 eV, respectively. The energy scale was referenced to the Au 4f_{1/2} peak at 84.0 eV.

The NEXAFS measurements were performed at the HE-SGM beamline of the synchrotron storage ring BESSY II in Berlin, Germany. The spectra acquisition was carried out at the carbon K-edge in the partial electron yield mode with a retarding voltage of -150 V. Linear polarized synchrotron light with a polarization factor of approx. 82% was used. The energy resolution was approx. 0.40 eV. The incidence angle of the light was varied to monitor the orientational order within the films. This approach is based on the linear dichroism in X-ray absorption, i.e. the strong dependence of the cross-section of the resonant photoexcitation process on the orientation of the electric field vector of the linearly polarized light with respect to the molecular orbital of interest. The raw NEXAFS spectra were normalized to the incident photon flux by division through a spectrum of a clean, freshly sputtered gold sample. The energy scale was referenced to the pronounced π₁* resonance of highly oriented pyrolytic graphite (HOPG) at 285.38 eV.

ISS measurements were performed with a focused ion gun (Leybold-Heraeus) and a LHS 11 analyzer. The primary ion beam (He⁺, MESSER 99.999%) was accelerated to 1 keV and operated at a current of approx. 100 nA/cm². The beam was focused to a spot with a diameter of ca. 500 µm by two focal lenses. The angle between the primary beam and sample surface was 35°. During data acquisition, the beam was rastered over a 2 x 2 mm² area, which was gated with a 70% aperture. The depth profiles of Ni and Au were measured by subsequent acquisition of the ISS spectra (both the Ni and Au signals were recorded in a single scan) with an energy window from 750 to 1000 eV during the erosion of the samples by the ISS beam.

AFM measurements were carried out with a Park Scientific Instruments "AutoProbe" model in ambient. A 5 µm scanner and a cantilever with silicon nitride (Si₃N₄) tip were used. In most experiments, the applied force was set to 12 nN, the gain was set to c.a. 1, with a scan rate of c.a. 2 Hz. Usually, an area of 2x2 µm² was scanned. From the measurements, the mean surface roughness (RMS: root mean square) was directly evaluated.

Electrochemical measurements, which included cyclic voltammetry and impedance spectroscopy, were carried out with an impedance measurement unit (IM6e, ZAHNER Elektrik) under an argon gas atmosphere at room temperature. An Ag/AgCl electrode and a Pt mesh electrode were used as the reference and counter electrodes, respectively. An aqueous solution of 0.1 M HClO₄ was used as an electrolyte. Prior to the electrochemical measurements, the electrolyte solution was deaµerated by bubbling argon gas for 15 min. Cyclic voltammograms were measured with a constant scan rate of 0.1 V s⁻¹ in the potential range between 0 and 0.6 V. Impedance spectra were taken between 100 kHz and 50 MHz under sinusoidal potentials with an amplitude of 10 mV. To estimate the electrochemical parameters from the data, the whole system was represented by ideal elements of a simplified equivalent circuit model composed of serial resistance *Rₛ,* interface capacitance C, and interface resistance Rₚ. As the reference, the impedance spectrum of the bare gold electrode was measured and the respective electrochemical parameters were calculated, assuming a double-layer formation at the gold electrode/electrolyte interface and the ohmic behaviour of the electrolyte solution and the contacts in the highfrequency regime.

### Analytical results

ISS is a technique that is capable to provide a direct information on the depth distribution of the metal adsorbate. In ISS experiment, an ion beam is directed onto a surface, and the energy distribution of the scattered ions is measured (a typical cross-section for the scattering is about 5-10x10⁻¹⁹ cm²/sr), which can be easily converted into mass spectra (E. Taglauer, in Surface Analysis - The Principal Techniques, Ed. J. C. Vickerman, Wiley, Chichester, 1997). In parallel, the erosion of the samples occurs, so that a depth profile of the mass of interest can be acquired by subsequent collection of the ISS spectra. Under the conditions of the experiments (³He⁺, 1 keV, 100 nA/cm², a scattering angle of 55°) , the erosion rate was about 0.05-0.1 Å/min, and no ion-induced intermixing occurred (Chenakin et al., Surf. Sci. 397, 84 (1998) ; 421, 337 (1999)).

The ISS depth profiles of Ni and Au for Ni/TPMT/Au and Ni/TPDMT/Au (θ_{Ni}=10.0) are presented in Figures 2a and 2b,respectively. For Ni/TPMT/Au, no Ni is observed at the SAM-ambient interface - all metal adsorbate atoms penetrated into the SAM and diffused to the SAM-Au interface. The Ni ISS profiles for Ni/TPDMT/Au (pristine), show a pronounced Ni signal on the SAM surface, but even a stronger signal at the SAM-Au interface, which can be easily traced by the appearing Au signal (the further growth of the Ni signal is related to the formation of a Ni-Au alloy)(Bigault et al., Phys. Rev. B 64, 125414 (2001)). Thus, the formation of the Ni film on the top of the TPDMT film is accompanied by the penetration of Ni to the SAM-Au interface. The penetration process is favoured by an extended SAM reorientation, mediated by the formation of Ni-thiol complexes at the SAM-ambient interface (see Tai et al., Appl. Phys. Lett. 85, 6257 (2004)). This results in the appearance of additional transient channels for the metal diffusion into the SAM and to the SAM-substrate interface.

The same analysis was carried out after cross-linking (CL) of the TPDMT films by electron irradiation. The respective Ni ISS depth profile in Figure 2c taken immediately after Ni evaporation exhibits a strong Ni signal on the top of the SAM and no signal within the SAM or at the SAM-Au interface. Thus, the diffusion of Ni into the film appears to be significantly reduced, and the Ni film is exclusively formed on the SAM surface.

This result is supported by the XPS data presented in Figure 3b. For CL-TPDMT/Au, XPS signal of Ni remains almost constant with increasing takeoff angle of the photoelectrons, whereas the carbon signal decreases due to the increasing attenuation by the nickel overlayer. This behaviour is just opposite to the respective angle dependences for the pristine TPDMT/Au (Figure 3a), where a dramatic decrease in the Ni signal and a persistence of the carbon signal with increasing takeoff angle of the photoelectrons are observed.

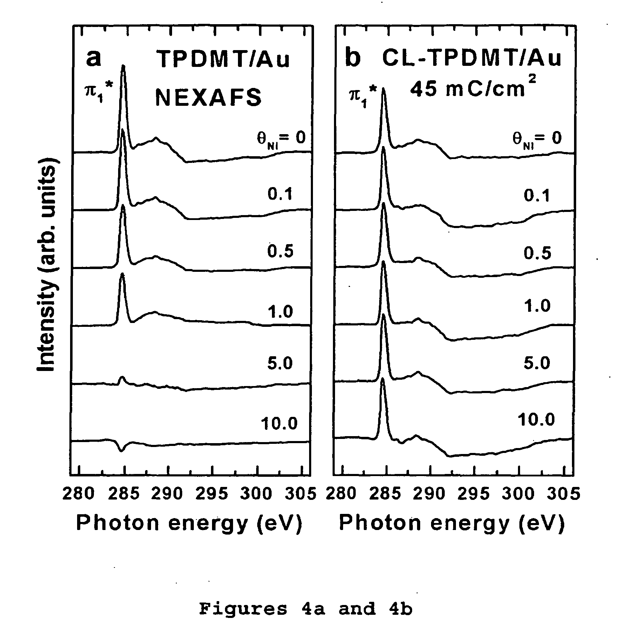

Further evidence that no penetration of Ni into CL-TPDMT/Au occurs is provided by NEXAFS data, which show that the orientational order in this film persists upon Ni evaporation and film formation. This is evidenced by the invariability of the respective difference NEXAFS spectra, presented in Figure 4b. Such spectra are a direct fingerprint of the orientational order and molecular tilt in the film - an oriented film exhibits pronounced difference peaks at the positions of the characteristic absorption resonances. The positive sign of the π₁* peak (at approx. 285 eV) in the spectra in Figure 4b is characteristic of an upright orientation of the SAM constituents, which is obviously preserved, even though a Ni layer is formed on top of the SAM. In the case of the Ni penetration, the orientational order is destroyed, which was observed for all systems of this study except for CL-TPDMT. An example is given in Figure 4a, where the difference NEXAFS spectra for the pristine TPDMT/Au are presented. The amplitude of the difference peaks decreases in the course of the Ni evaporation, until it becomes negligibly small at θ_{Ni} = 5-10, which corresponds to a fully disordered film. Note that a similar disordering is typical for metal adsorption onto the SAM substrates described in previous work (Czanderna et al., Crit. Rev. Sol. State Mat. Sci. 1994, 19, 1; Epple et al., Langmuir 2002, 18, 773 ; Walker et al. Appl. Phys. Lett. 2004, 84, 4008).

This Ni film formed on the surface of CL-TPDMT/Au is stable, as shows the comparison between the ISS profiles of Ni taken in 3 min and 24 hours after the evaporation (Figure 2c). AFM data suggest a low roughness of this film, which is presumably related to the occurrence of the nucleation centres for the film growth, provided by the thiol headgroups. Without these centres, a 3D growth mode for the Ni overlayer will occur, - the roughness (RMS: root mean square) of this layer increases by a factor of 5 as compared to Ni/CL-TPDMT/Au, where it was less than 0.5 nm (θ_{Ni}=5-6). In addition, the presence of the thiol tailgroups improves the adherence of the Ni film to the SAM support - due to the chemical anchoring by formation of Ni thiolate links at the SAM-ambient interface.

The persistence of the orientational order and full suppression of the Ni diffusion into the SAM are good prerequisites for device applications of CL-TPDMT/Au. Electrochemical measurements showed that the insulator properties of this film are not affected by Ni evaporation - the resistance and capacitance of the cross-linked SAM in the Ni-TPDMT-Au sandwich are 13.6 MΩcm² and 1.1 µF cm⁻², respectively, which are very close to the values, which were observed for this film before Ni evaporation (14.4 MΩ cm² and 1.36 µF cm⁻², respectively). Interestingly, the cross-linking even improves the insulator parameters of the TPDMT layer - the resistance of the pristine TPDMT film was estimated as 5.7 MΩ cm² _{.}

## Claims

1. A layer system, comprising a substrate, being either a bulk substrate or a thin film deposited on it, a monolayer of organic molecules chemisorbed on the substrate which is cross-linked in the lateral direction, and a deposited electrically conductive, ferromagnetic or semiconductor layer on top of the monolayer, wherein the layer system has a resistance in the range of 10 MΩcm² or more.

2. The layer system according to claim 1, wherein the substrate is made of one or more of the metals gold, silver, copper, aluminium, iron, cobalt, nickel, or a semiconductor, the substrate being either a bulk substrate or a thin film deposited on it.

3. The layer system according to any one of the preceding claims, wherein the top layer is an electrically conductive layer made of one or more of the metals gold, silver, copper, aluminium, or palladium.

4. The layer system according to any one of the preceding claims, wherein the top layer is a ferromagnetic layer made of one or more 3d or 4d metals.

5. The layer system according to claim 4, wherein the substrate is ferromagnetic, the substrate being either a bulk substrate or a thin film deposited on it.

6. The layer system according to any one of the preceding claims, wherein the chemisorbed molecules comprise an aromatic or heteroaromatic moiety.

7. The layer system according to claim 6, wherein the aromatic or heteroaromatic moiety is selected from the group consisting of phenyl, biphenyl, terphenyl, naphthalene, anthracene, pyridin, bipyridin, terpyridin, thiophen, bithienyl, terthienyl, and pyrrol.

8. The layer system according to any one of the preceding claims, wherein the chemisorbed molecules are cross-linkable by subjecting the same to electron irradiation, X-ray irradiation, or UV irradiation.

9. The layer system according to any one of the preceding claims, wherein the chemisorbed molecules comprise a functional group selected from -SH, -OH, -COOH, -COOCH3, - CH2OH, or -NH2 on which the top layer is deposited.

10. The layer system according to any one of the preceding claims, wherein the chemisorbed molecules form a self-assembled monolayer.

11. The layer system according to any one of the preceding claims, which is a gate dielectric in a transistor assembly.

12. The layer system film according to any one of claims 1 to 10, which is a magnetic tunnel junction.

13. A microelectronic device comprising the layer system of one or more of the preceding claims.

## Patentansprüche

1. Schichtsystem, das ein Substrat, das entweder ein Bulksubstrat oder ein darauf abgeschiedener dünner Film ist, eine auf dem Substrat chemisorbierte Monoschicht organischer Moleküle, die in lateraler Richtung vernetzt ist, und eine auf der Oberseite der Monoschicht abgeschiedene elektrisch leitfähige, ferromagnetische oder halbleitende Schicht umfasst, worin das Schichtsystem einen Widerstand im Bereich von 10 MΩcm² oder mehr hat.

2. Schichtsystem gemäß Anspruch 1, worin das Substrat aus einem oder mehreren der Metalle Gold, Silber, Kupfer, Aluminium, Eisen, Kobalt, Nickel, oder einem Halbleiter hergestellt ist, und das Substrat entweder ein Bulksubstrat oder ein darauf abgeschiedener dünner Film ist.

3. Schichtsystem gemäß mindestens einem der vorhergehenden Ansprüche, worin die Oberschicht eine elektrisch leitfähige Schicht ist, die aus einem oder mehreren der Metalle Gold, Silber, Kupfer, Aluminium oder Palladium hergestellt ist.

4. Schichtsystem gemäß mindestens einem der vorhergehenden Ansprüche, worin die Oberschicht eine ferromagnetische Schicht ist, die aus einem oder mehreren 3d oder 4d Metallen hergestellt ist.

5. Schichtsystem gemäß Anspruch 4, worin das Substrat ferromagnetisch ist, und das Substrat entweder ein Bulksubstrat oder ein darauf abgeschiedener dünner Film ist.

6. Schichtsystem gemäß mindestens einem der vorhergehenden Ansprüche, worin die chemisorbierten Moleküle eine aromatische oder heteroaromatische Gruppe umfassen.

7. Schichtsystem gemäß Anspruch 6, worin die aromatische oder heteroaromatische Gruppe ausgewählt ist aus Phenyl, Biphenyl, Terphenyl, Naphthalin, Anthracen, Pyridin, Bipyridin, Terpyridin, Thiophen, Bithienyl, Terthienyl und Pyrrol.

8. Schichtsystem gemäß mindestens einem der vorhergehenden Ansprüche, worin die chemisorbierten Moleküle vernetzbar sind, indem sie Elektronenbestrahlung, Röntgenbestrahlung oder UV-Bestrahlung ausgesetzt werden.

9. Schichtsystem gemäß mindestens einem der vorhergehenden Ansprüche, worin die chemisorbierten Moleküle eine aus -SH, -OH, -COOH, -COOCH₃, -CH₂OH oder -NH₂ ausgewählte funktionelle Gruppe umfassen, auf der die Oberschicht abgeschieden wird.

10. Schichtsystem gemäß mindestens einem der vorhergehenden Ansprüche, worin die chemisorbierten Moleküle eine selbststrukturierte (self-assembled) Monoschicht bilden.

11. Schichtsystem gemäß mindestens einem der vorhergehenden Ansprüche, das ein Gate-Dielektrikum in einem Transistoraufbau ist.

12. Schichtsystem-Film gemäß mindestens einem der Ansprüche 1 bis 10, der eine magnetische Tunnelverbindung (magnetic tunnel junction) ist.

13. Mikroelektronisches Gerät, das das Schichtsystem gemäß einem oder mehreren der vorhergehenden Ansprüche umfasst .

## Revendications

1. Système en couches, comprenant un substrat, étant soit un substrat massif, soit un film mince déposé sur celui-ci, une monocouche de molécules organiques chimisorbées sur le substrat qui est réticulée dans la direction latérale, et une couche électro-conductrice, ferromagnétique ou semi-conductrice déposée par-dessus la monocouche, dans lequel le système en couches a une résistance dans la plage de 10 MΩm² ou plus.

2. Système en couches selon la revendication 1, dans lequel le substrat est constitué d'un ou plusieurs des métaux or, argent, cuivre, aluminium, fer, cobalt, nickel, ou d'un semi-conducteur, le substrat étant soit un substrat massif, soit un film mince déposé sur celui-ci.

3. Système en couches selon l'une quelconque des revendications précédentes, dans lequel la couche supérieure est une couche électro-conductrice constituée d'un ou plusieurs des métaux or, argent, cuivre, aluminium, ou palladium.

4. Système en couches selon l'une quelconque des revendications précédentes, dans lequel la couche supérieure est une couche ferromagnétique constituée d'un ou plusieurs des métaux 3d ou 4d.

5. Système en couches selon la revendication 4, dans lequel le substrat est ferromagnétique, le substrat étant soit un substrat massif, soit un film mince déposé sur celui-ci.

6. Système en couches selon l'une quelconque des revendications précédentes, dans lequel les molécules chimisorbées comprennent un groupe caractéristique aromatique ou hétéroaromatique.

7. Système en couches selon la revendication 6, dans lequel le fragment aromatique ou hétéroaromatique est choisi dans le groupe constitué par un phényle, un biphényle, un terphényle, un naphtalène, un anthracène, une pyridine, une bipyridine, une terpyridine, un thiophène, un bithiényle, un terthiényle, et un pyrrole.

8. Système en couches selon l'une quelconque des revendications précédentes, dans lequel les molécules chimisorbées sont réticulables en soumettant celles-ci à un rayonnement d'électrons, un rayonnement de rayons X, ou un rayonnement UV.

9. Système en couches selon l'une quelconque des revendications précédentes, dans lequel les molécules chimisorbées comprennent un groupe fonctionnel choisi parmi -SH, -OH, -COOH, -COOCH₃, -CH₂OH ou -NH₂ sur lequel la couche supérieure est déposée.

10. Système en couches selon l'une quelconque des revendications précédentes, dans lequel les molécules chimisorbées forment une monocouche auto-assemblée.

11. Système en couches selon l'une quelconque des revendications précédentes, qui est un diélectrique de grille dans un ensemble de transistors.

12. Film de système en couches selon l'une quelconque des revendications 1 à 10, qui est une jonction tunnel magnétique.

13. Dispositif microélectronique comprenant le système en couches selon une ou plusieurs des revendications précédentes.
